# EUROPEAN PATENT APPLICATION

(11) **EP 4 790 868 A1**
(43) Date of publication of application: **12.08.2026**
(21) Application number: 26156209.4
(22) Date of filing: 04.02.2026
(51) Int. Cl.: H02J 7/90, G01R 31/389, H02J 7/64, H02J 7/84

(54) **METHOD AND APPARATUS FOR CONTROLLING BATTERY CHARGING**

(30) Priority: 10.02.2025 KR 20250016568
(71) Applicant: SAMSUNG SDI CO., LTD., Yongin-si, Gyeonggi-do 17084 (KR)
(72) Inventor: SEOL, Junha, Yongin-si, Gyeonggi-do 17084 (KR)
(74) Representative: Meissner Bolte Partnerschaft mbB

(57) **Abstract**

Provided are a method and apparatus (700) for controlling charging of a battery. The method of controlling charging of a battery (120) includes: measuring (210) a first impedance and a second impedance of the battery (120); calculating (220) an impedance variation based on a difference between the first impedance and the second impedance; setting (230) an end-of-charge voltage based on the impedance variation; and charging (240) the battery based on the end-of-charge voltage.

## Description

### BACKGROUND

### 1. Field

The invention relates to a method and apparatus for controlling charging of a battery.

### 2. Description of the Related Art

During the charging of electric vehicle (EV) batteries, there is a risk of fire and explosion, such as during fast charging or high-current charging, where the risk is known to be concentrated. This is because the electrochemical reactions within the battery are more likely to proceed in an unstable manner during the charging process. Such accidents not only pose a threat to the safety of the vehicle and driver but also undermine trust in electric vehicles, which may have a negative impact on the global goal of transitioning to renewable energy. Accordingly, preventing such accidents is becoming an important issue both technologically and socially.

To address the above, a technological approach that enhances the charging control function of a battery management system (BMS) throughout a charging process (e.g., an entire charging process) may be desired. In this regard, a technology that measures with relative precision and analyzes an internal state of a battery using electrochemical impedance spectroscopy (EIS) before the start of charging may play a role in providing safety of the charging process. By monitoring the battery's impedance status (e.g., in real time) through EIS, signs of abnormalities in the state of the battery may be detected during the charging process and, based on such detection, modify (e.g., optimize) the charging current and voltage to help reduce or effectively prevent fire and explosion accidents.

Furthermore, fast charging and high-current charging may be desirable for increasing the charging speed and efficiency of EV batteries, but they may also involve inherent risks, which may call for control technologies for providing safety and performance.

The aforementioned background technology consists of technical information that the inventors either possessed for deriving this invention or acquired during its development process. Therefore, it cannot necessarily be considered publicly known technology that was disclosed to the general public prior to the filing of the present application.

### SUMMARY

The invention provides a method and apparatus for controlling charging of a battery. The objective of the invention is not limited to the above-mentioned objective, and other objectives and advantages of the invention which have not been mentioned above may be understood by the following description and become more apparent from embodiments of the invention. Furthermore, it will be understood that aspects and advantages of the invention may be achieved by via the elements set forth in claims and combinations thereof.

A first aspect of the invention provides a method for controlling charging of a battery, the method including: measuring a first impedance and a second impedance of the battery; calculating an impedance variation based on a difference between the first impedance and the second impedance; setting an end-of-charge voltage based on the impedance variation; and charging the battery based on the end-of-charge voltage.

A second aspect of the invention provides an apparatus for controlling charging of a battery, the apparatus including: a processor; and a memory, where the memory stores program instructions that, when executed by the processor, cause the processor to: measure a first impedance and a second impedance of the battery; calculate an impedance variation based on a difference between the first impedance and the second impedance; set an end-of-charge voltage based on the impedance variation; and charge the battery based on the end-of-charge voltage.

A third aspect of the invention provides a computer-readable, non-transitory recording medium having recorded thereon a program for executing the method of the first aspect of the invention in a computer.

Other aspects, features and advantages other than those described above will become apparent from the following drawings, claims and detailed description of the invention.

### BRIEF DESCRIPTION OF THE DRAWINGS

The accompanying drawings illustrate at least one embodiment of the invention, and together with the detailed description of the invention described below, serve to provide further understanding of the technical aspects of the invention, and thus, the invention is not construed as being limited to the statements set forth in the drawings in which:
FIG. 1 is a block diagram of a system for controlling charging of a battery according to one or more embodiments of the present invention;
FIG. 2 is a flowchart of a method for controlling charging of a battery according to one or more embodiments of the present invention;
FIG. 3 is a graph showing the results of measuring the impedance of a battery at different points in time using electrochemical impedance spectroscopy according to one or more embodiments of the present invention;
FIG. 4 is a diagram of an example method for setting an end-of-charge voltage based on an impedance variation according to one or more embodiments of the present invention;
FIG. 5 is a flowchart of a method for setting an end-of-charge voltage based on an impedance variation according one or more embodiments of the present invention;
FIG. 6 is a flowchart of a process for terminating charging by monitoring the temperature of a battery according to one or more embodiments of the present invention; and
FIG. 7 is a block diagram of a battery management device according to one or more embodiments of the present invention.

### DETAILED DESCRIPTION

Advantages and features of the invention and methods for achieving them will become apparent by reference to the embodiments described in detail together with the accompanying drawings. However, the description of particular embodiments is not intended to limit the invention to the particular embodiments disclosed herein, but on the contrary, it should be understood that the invention is to cover all modifications, equivalents and alternatives falling within the spirit and scope of the invention. The embodiments disclosed below are provided so that the invention will be thorough and complete, and also to provide a more complete understanding of the scope of the invention to those of ordinary skill in the art. In the interest of clarity, not all details of the relevant art are described in detail in the present specification if it is determined that such details are not necessary to obtain a complete understanding of the invention.

The terminology used herein is for the purpose of describing particular embodiments only and is not intended to be limiting. Unless otherwise defined, all terms used herein have the same meaning as commonly understood by those of ordinary skill in the art to which this invention pertains.

In this specification, the singular forms "a," "an," and "the" may be intended to include the plural forms as well, unless the context clearly indicates otherwise. Furthermore, it should be understood that the terms "comprise," "include," and "have," as used herein, are inclusive and therefore specify the presence of stated features, integers, steps, operations, components, parts, or combinations thereof, but do not preclude the possibility of the presence or addition of one or more other features, integers, steps, operations, components, parts, or combinations thereof.

Additionally, it will be understood that, although the terms including the ordinal number such as "first", "second" and the like may be used herein to describe various components, these components should not be limited by the terms. These terms are only used to distinguish one component from another.

The expressions "in an embodiment," "according to an embodiment," "related to an embodiment," and "according to an implementation of an embodiment," as used in this specification, do not necessarily indicate the same embodiment. Additionally, throughout the specification, embodiments are arbitrary distinctions intended to facilitate the description of the invention, and the respective embodiments need not be mutually exclusive. For example, configurations disclosed in one embodiment may be applied to and/or implemented in other embodiments and may be applied and/or implemented with modifications, without departing from the scope of the invention.

Some embodiments of the invention may be described in terms of functional block components and various processing steps. Some or all of such functional blocks may be realized by any number of hardware and/or software components configured to perform the specified functions. For example, functional blocks according to the invention may be realized by one or more microprocessors or by circuit components for a given function.

For example, the functional blocks of the invention may be implemented with various programming or scripting languages. The functional blocks may be implemented in algorithms that are executed on one or more processors based on program instructions stored in memory. Furthermore, the invention described herein may employ any number of techniques according to the related art for electronics configuration, signal processing and/or control, data processing, and the like. The terms "mechanism", "element", "means", and "configuration" are used broadly and are not limited to mechanical or physical embodiments. Additionally, the terms "unit", "-or/er" and "module" should be understood as a unit in which at least one function or operation is processed, and the unit, -or/er, or module may be embodied as hardware, software, or a combination of hardware and software.

Furthermore, the connecting lines, or connectors shown in the drawings presented are intended to represent exemplary functional relationships and/or physical or logical couplings between various elements. It should be noted that many alternative or additional functional relationships, physical connections, or logical connections may be present in a practical apparatus.

Additionally, the sizes or proportions of some elements shown in the drawings may be exaggerated. Additionally, some elements shown in one drawing may not be shown in other drawings.

Hereinafter, the invention will be described in detail with reference to the attached drawings.

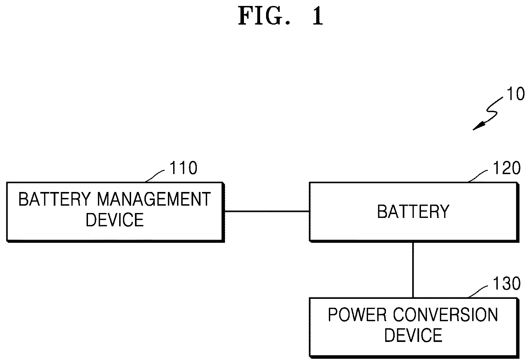

FIG. 1 is a block diagram of a system 10 for controlling charging of a battery according to one or more embodiments of the present invention.

Referring to FIG. 1, the system 10 for controlling charging of a battery may include a battery management device 110, a battery (or battery pack) 120, and a power conversion device 130. The system 10 may be part of an energy storage system EMS that stores and supplies electricity, or a battery management system BMS that monitors the state of the battery 120 to reduce or prevent overcharging, but is not limited thereto.

In an embodiment, the battery management device 110 may refer to a device for monitoring the state of the battery 120 within the system. The battery management device 110 may monitor the voltage, current, temperature, and the like of the battery 120 through sensors included in the device, and may predict state information of the battery 120 based thereon. In some embodiments, the battery management device 110 may predict the state information of the battery 120, such as a state of charge (SoC) and/or a state of health (SoH) of the battery 120.

According to an embodiment, the battery management device 110 may monitor the state of charge and discharge of the battery 120 for performing cell balancing. In some embodiments, the battery management device 110 may perform cell balancing by adjusting the current and voltage of one or more (e.g., each) battery cell to reduce charging voltage deviations among the battery cells.

In an embodiment, the battery 120 may refer to a device for supplying power to a load (not shown). The battery 120 may be configured as a battery module or a battery pack. For example, the battery 120 may be a battery pack mounted in an electric vehicle (EV) as a power source for the EV, and may supply power to a motor of the EV. A battery module or battery pack 120 may include one or more battery cells that can be charged and discharged.

In an embodiment, the power conversion device 130 may be a device capable of converting alternating current to direct current, or vice versa. The power conversion device 130 according to an embodiment may supply power to charge the battery 120 depending on the state of charge and discharge of the battery 120, and may supply power stored in the battery 120 to a load (not shown) when the battery 120 is discharged.

For example, the power conversion device 130 may convert AC power generated from renewable energy sources such as photovoltaic power generation and wind power generation into DC power and deliver it to the battery 120. In another example, the power conversion device 130 may convert direct current power stored in the battery 120 into alternating current power and supply it to the load.

In an embodiment, the battery management device 110, the battery 120, the power conversion device, and other external devices (e.g., an entity that collects information on the battery pack and performs database construction and data preprocessing, etc.) may exchange data with each other by performing communication through a network.

In some embodiments, the network is a data communication network in a broad sense that enables different entities to communicate with one another (e.g., seamlessly), and may include wired Internet, wireless Internet, and/or a mobile wireless communication network. For example, the network may include a local area network (LAN), a wide area network (WAN), a value added network (VAN), a mobile radio communication network, a satellite communication network, and combinations thereof.

Examples of wired communication may include, but are not limited to, Ethernet and fiber optic networks. In some embodiments, examples of wireless communication may include, but are not limited to, wireless LAN (Wi-Fi), Bluetooth, Bluetooth low energy, ZigBee, Wi-Fi Direct (WFD), ultra-wideband (UWB), infrared data communication (IrDA), near-field communication (NFC), and the like.

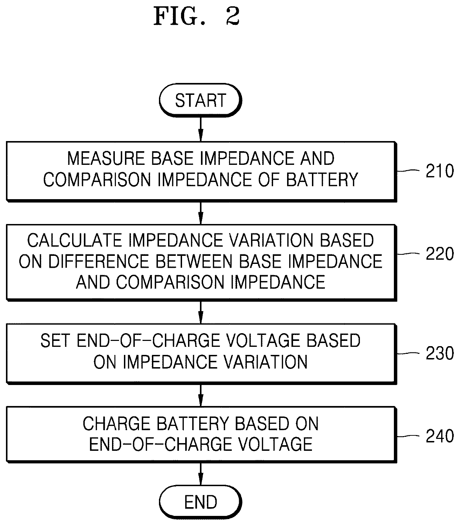

FIG. 2 is a flowchart of a method for controlling charging of a battery 120 according to one or more embodiments of the present invention.

Referring to FIG. 2, in an embodiment, a battery management device 110 (hereinafter referred to as "device") may measure a first or base impedance and a second or comparison impedance of a battery 120, and calculate an impedance variation based on a difference between the base impedance and the comparison impedance. The device 110 may set an end-of-charge voltage based on the impedance variation and control the battery 120 to be charged according to the set end-of-charge voltage. The device 110 may control a power conversion device so that the battery 120 is charged until the end-of-charge voltage is reached.

According to an embodiment, the base impedance and the comparison impedance may be measured using electrochemical impedance spectroscopy (EIS). The base impedance and the comparison impedance may refer to values obtained by measuring the electrochemical impedance of the battery 120 at different points in time. In some embodiments, the electrochemical impedance may be measured using EIS. In general terms, EIS is a technique that may be used to analyze the electrical characteristics of an electrochemical system such as the battery 120, and may represent the impedance of the battery 120 in the form of frequency by applying alternating current signals of various frequencies to the system.

According to an embodiment, the device 110 may measure the base impedance at the time of completion of initial charge and measure the comparison impedance at a point in time after the battery 120 is discharged. In some embodiments, the time of completion of initial charge may refer to a point in time after the battery 120 is manufactured and shipped, but before any degradation of the battery 120 occurs. In some embodiments, the point in time after discharge of the battery 120 may refer to a point in time at which the battery 120, after undergoing at least one charging cycle, is discharged and reaches a rest state.

According to some embodiments, the base impedance may be measured at a first discharging time point, and the comparison impedance may be measured at a second discharging time point. In some embodiments, the first discharging time point and the second discharging time point may each refer to a point in time when the battery 120, after undergoing at least one charging cycle, is discharged and reaches a rest state. In some embodiments, the second discharging time point may refer to a point in time after at least one additional charging cycle has been performed after the first discharging time point.

According to an embodiment, the device 110 may calculate an impedance variation based on the difference between the base impedance and the comparison impedance measured at the same frequency. In some embodiments, the base impedance and the comparison impedance may each include impedance values corresponding to one or more frequency sections. The impedance variation may be calculated by comparing one or more (e.g., each) impedance value of the base impedance and the comparison impedance corresponding to one or more frequency sections. In this case, the impedance variation may represent the degree of change in the comparison impedance relative to the base impedance as a percentage (%).

According to an embodiment, the device 110 may compare the impedance variation with a reference value, and change the end-of-charge voltage based on the impedance variation being greater than the reference value. In some embodiments, the reference value may be determined in consideration of one or more factors such as the specifications of the battery module pack, and may be set, for example, to 1% of the impedance at the time of shipment. The end-of-charge voltage may refer to the voltage at which the battery 120 terminates charging. In some embodiments, based on the voltage of the battery 120 reaching the end-of-charge voltage, the device may control the charging of the battery 120 to end. In this regard, the charging of the battery 120 may stop based on reaching the end-of-charge voltage.

According to an embodiment, the device 110 may downwardly adjust or decrease the end-of-charge voltage based on the impedance variation being a positive (+) value, and may upwardly adjust or increase the end-of-charge voltage based on the impedance variation being a negative (-) value.

According to an embodiment, the device 110 may divide a selected voltage between the voltage (a first voltage) at the start of charging and the end-of-charge voltage associated with end of the charging of the battery, into one or more voltage sections, and may generate one or more temperature sections corresponding to the respective voltage sections. The one or more generated temperature sections may be formed by dividing a selected temperature between a first temperature at the start of charging of the battery and a second (e.g., a critical) temperature of the battery, into one or more sections.

According to an embodiment, the one or more temperature sections are divided according to at least one reference temperature and the reference temperature may be set to a temperature that does not exceed the critical temperature. In some embodiments, the reference temperature may refer to a temperature that serves as a criterion for determining whether to reduce the amount of charging current, and a plurality of reference temperatures may be set for one or more (e.g., each) battery 120. The critical temperature may refer to a temperature that serves as a criterion for determining the risk of fire or explosion of the battery 120, and one critical temperature may be set for one or more (e.g., each) battery 120. In some embodiments, the reference temperature and the critical temperature may be set differently for one or more (e.g., each) battery 120 in consideration of the specifications or the like of the battery module pack.

According to an embodiment, the device 110 may measure a temperature (referred to as a measured temperature) of the battery 120 at a selectable voltage section included in the plurality of voltage sections, compare the measured temperature with the reference temperature, and reduce the amount of charging current based on the measured temperature exceeding the reference temperature.

According to an embodiment, the device 110 may measure the temperature of the battery 120 and terminate charging of the battery 120 based on the measured temperature exceeding the critical temperature.

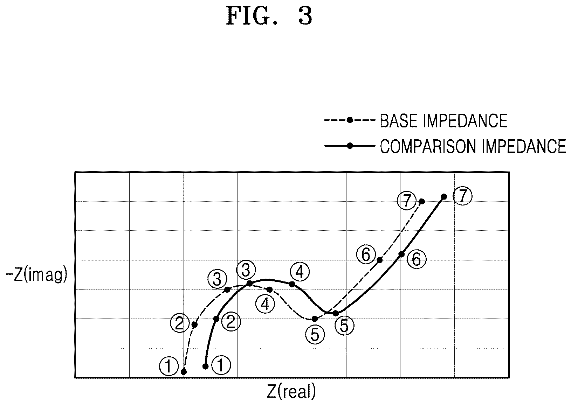

FIG. 3 is a graph showing the results of measuring the impedance of the battery 120 at different points in time using electrochemical impedance spectroscopy according to one or more embodiments of the present invention.

According to an embodiment, the device 110 may measure the base impedance and the comparison impedance using EIS. The device 110 may control the charging of the battery 120 by measuring the electrochemical impedance, including both real and imaginary parts, using EIS.

According to an embodiment, the device 110 may measure the base impedance at the time of completion of initial charge and measure the comparison impedance at a point in time after the battery 120 is discharged. According to some embodiments, the device 110 may measure the base impedance at the first discharging time point and measure the comparison impedance at the second discharging time point. Referring to FIG. 3, the base impedance and comparison impedance values measured by frequency using EIS may be represented as a Nyquist plot.

According to an embodiment, the device 110 may measure the impedance variation at different points in time, on a per preset frequency unit basis. For example, the device 110 may measure the base impedance at first to seventh frequencies that respectively correspond to first to seventh comparison points shown in FIG. 3. In some embodiments, the device 110 may measure the comparison impedance at the first to seventh frequencies corresponding respectively to the first to seventh comparison points. In this case, the frequencies used to measure impedances at the same comparison point may be set to be the same. For example, at the first comparison point, the first frequency used to measure the base impedance and the first frequency used to measure the comparison impedance may be set to be the same.

The device 110 may calculate the impedance variation corresponding to one or more (e.g., each) comparison point based on the base impedance and the comparison impedance. In some embodiments, the impedance variation Δ*Z* may be calculated using Equation 1 below. $Δ Z = \left(\frac{\left|{Z}_{comparison}\right|}{\left|{Z}_{base}\right|}-1\right) \times 100 \left(%\right)$ where *Z_{comparison}* is the comparison impedance and *Z_{base}* is the base impedance.

In some embodiments, the impedance variation may be calculated based on the magnitude of the comparison impedance relative to the base impedance. Examples of the impedance variation corresponding to each comparison point, calculated using Equation 1, and the average impedance variation derived therefrom are shown in Table 1 below.

**Table 1**

| Comparison | Impedance Variation |
|---|---|
| 1 | +2 % |
| 2 | +3 % |
| 3 | +2 % |
| 4 | +3 % |
| 5 | +1 % |
| 6 | +1 % |
| 7 | +2 % |
| average | +2 % |

In some embodiments, the device 110 may calculate the impedance variation based on the difference between the base impedance and the comparison impedance measured at the same frequency, and one or more (e.g., each) measured impedance value may include a plurality of impedance values corresponding to one or more frequency sections. In this case, the device 110 may calculate one or more (e.g., each) impedance variation corresponding to one or more (e.g., each) frequency section, and may derive an average impedance variation through an arithmetic mean for one or more (e.g., each) impedance variation.

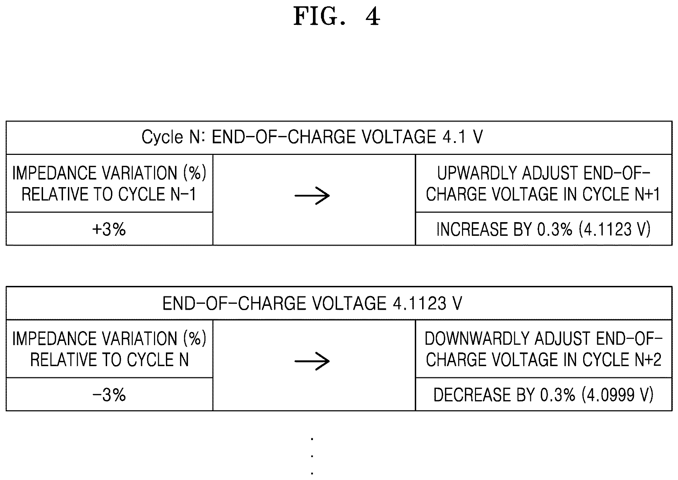

FIG. 4 is a diagram of an example method for setting an end-of-charge voltage based on an impedance variation based on performing a charging cycle one or more times (e.g., repeatedly performing the charging cycle) according to one or more embodiments of the present invention.

According to an embodiment, the device 110 may compare the impedance variation with a preset reference value, and change the end-of-charge voltage based on the impedance variation being greater than the reference value. In some embodiments, the impedance variation may be a value calculated by comparing not only the impedance at the time of shipment, but also the impedance at the first discharging time point and the second discharging time point after one or more (e.g., repeated) execution of charging cycles.

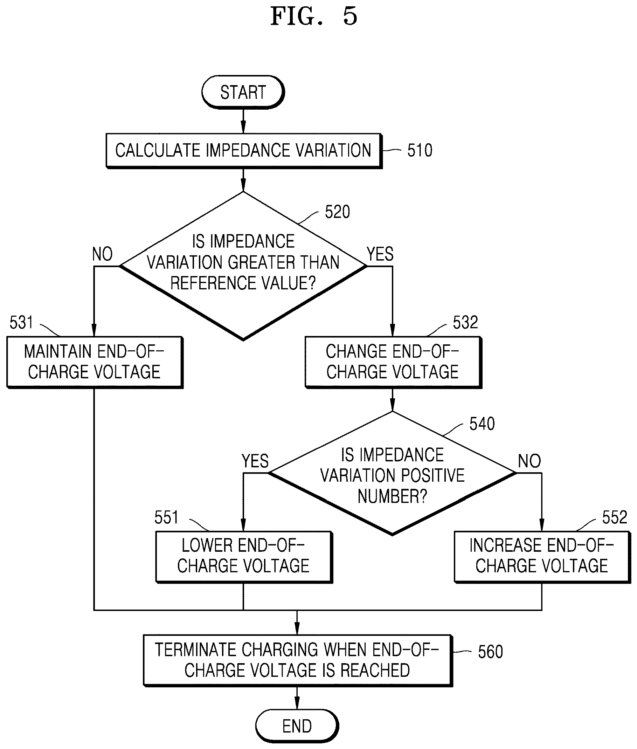

In this case, the device 110 may change the end-of-charge voltage when an absolute value of the impedance variation is greater than the reference value. For example, in the case where the preset reference value is 1% relative to the value at the time of shipment, the device 110 may change the end-of-charge voltage when the impedance variation is +3% or -3% relative to the impedance at the time of shipment. In this way, the device 110 may flexibly change the end-of-charge voltage by checking the impedance variation relative to the impedance at the time of shipment when the module pack is used (e.g., each time the module pack is used). This will be described further below with reference to FIG. 5.

According to an embodiment, the device 110 may upwardly adjust or increase the end-of-charge voltage to be higher than a prior end-of-charge voltage based on the impedance variation being a positive (+) value greater than a preset reference value. For example, in an arbitrary charging cycle N (Cycle N), the end-of-charge voltage may be 4.1 V and the impedance variation may increase by +3% compared to the previous cycle (Cycle N-1). In some embodiments, the charging cycle may refer to a cycle defined as one instance in which the fully charged battery 120 is discharged. In this case, the device 110 may control the end-of-charge voltage in the next cycle (Cycle N+1) to be increased by 0.3%.

Increasing the end-of-charge voltage may be to increase the charging capacity and extend the charging duration. This may raise the end-of-charge voltage in order to increase the temporarily reduced capacity and maintain consistent charging capacity since the total capacity up to the end-of-charge voltage decreases when degradation of the battery 120 (e.g., an increase in impedance) occurs and the end-of-charge voltage remains unchanged.

In some embodiments, the device 110 may downwardly adjust or decrease the end-of-charge voltage based on the impedance variation being a negative (-) value smaller than the preset reference value. For example, in an arbitrary charging cycle N+1, the end-of-charge voltage may be 4.1123 V, and the impedance variation may decrease by -3% compared to the previous cycle (Cycle N). In this case, the device 110 may control the end-of-charge voltage in the next cycle (Cycle N+2) to decrease by 0.3 %.

Reducing the end-of-charge voltage may cause charging to end earlier than in the previous cycles. This may lower the upper limit of the end-of-charge voltage in order to reduce the temporarily increased capacity and maintain consistent charging capacity, since the total capacity up to the end-of-charge voltage increases when degradation of the battery 120 (e.g., a decrease in impedance) occurs and the end-of-charge voltage remains unchanged.

FIG. 5 is a flowchart of a method for setting an end-of-charge voltage based on an impedance variation according to one or more embodiments of the present invention.

According to an embodiment, in operation 510, the device 110 may calculate an impedance variation, and in operation 520, may determine whether the impedance variation is greater than a preset reference value. In this case, when there is no impedance variation, or when the impedance variation is less than or equal to the preset reference value, the device 110 may maintain the end-of-charge voltage without change in operation 531. In some embodiments, when the impedance variation is less than or equal to the reference value, the device 110 may charge the battery 120 while maintaining the charging capacity within the usage range set at the time of shipment of the battery 120.

When the impedance variation is greater than the preset reference value, the device 110 may change the end-of-charge voltage in operation 532. A state in which the impedance variation is greater than the reference value may indicate that degradation of the battery 120 has begun. Accordingly, in this case, the increase and decrease in impedance may be monitored to track (e.g., continuously track) the state of the battery 120.

In some embodiments, when the impedance variation is a positive number, that is, when the impedance has increased compared to a previous point in time, the device 110 may adjust the end-of-charge voltage to be lowered in operation 551. In some embodiments, the device 110 may cause charging of the battery 120 to be terminated at a lower voltage than before.

On the other hand, when the impedance variation is a negative number, that is, when the impedance has decreased compared to the previous point in time, the device 110 may adjust the end-of-charge voltage to be increased in operation 552. In some embodiments, the device 110 may cause charging of the battery 120 to be terminated at a higher voltage than before. In this way, the device 110 may expand the usable range of the battery 120 and secure capacity.

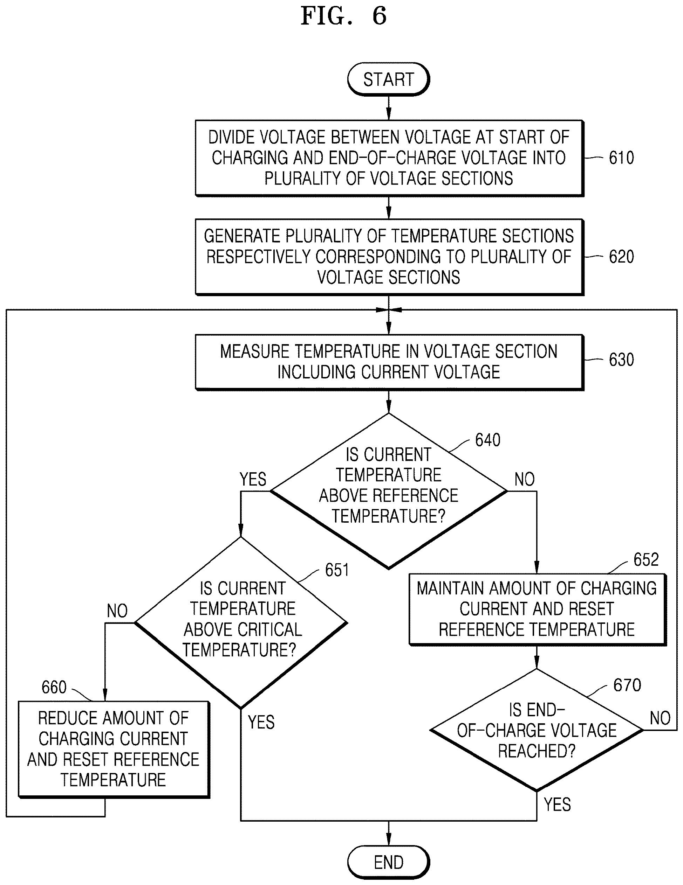

After the device 110 monitors the impedance variation and sets the corresponding end-of-charge voltage, charging may be terminated in operation 560 based on the voltage of one or more (e.g., each) battery 120 reaching the set end-of-charge voltage. In some embodiments, the device 110 may monitor the temperature along with the voltage to provide or ensure the safety of the battery 120, and this will be described below with reference to FIG. 6.

FIG. 6 is a flowchart of a process for terminating charging by monitoring the temperature of the battery 120 according to one or more embodiments of the present invention.

According to an embodiment, in operation 610, the device 110 may divide the voltage between the voltage at the start of charging and the end-of-charge voltage into a plurality of voltage sections. In some embodiments, in operation 620, the device 110 may generate a plurality of temperature sections corresponding to the respective voltage sections. The plurality of generated temperature sections may be formed by dividing the temperature between the temperature at the start of charging and a second or critical temperature into multiple sections.

For example, when the temperature at the start of charging is 35 °C and a preset critical or second temperature of the battery 120 is 65 °C, the device 110 may divide the range between 35 °C and 65 °C into predetermined or selected sections and monitor the temperature of the battery 120. For example, the device 110 may divide the temperature range into five sections and monitor the temperature of the battery 120 at intervals of 5 °C.

According to an embodiment, the plurality of temperature sections are divided according to at least one reference temperature and the reference temperature may be set to a temperature that does not exceed the critical or second temperature. For example, if the temperature range between 35 °C and 65 °C is monitored at intervals of 5 °C as described above, the reference temperatures for the corresponding sections may be 40 °C, 45 °C, 50 °C, 55 °C, and 60 °C, respectively.

In operation 630, the device 110 may measure a temperature in a voltage section including the current voltage among the plurality of voltage sections. In this case, in operation 640, the device 110 may measure the temperature of the battery 120 within a certain voltage section included in the plurality of voltage sections and compare the measured temperature with a preset or identified reference temperature.

In an embodiment, when the measured temperature exceeds the reference temperature, the device 110 may compare the measured temperature with a second or a preset critical temperature in operation 651. When the measured temperature is a high temperature that exceeds the second or preset critical temperature, the device 110 may cause charging of the battery 120 to be terminated. Through this, when it is determined that the temperature of the battery 120 has excessively increased or satisfied an increase criterion and the possibility of heat generation or fire is high or satisfied, the device 110 may terminate charging to provide safety during charging of the battery 120.

In some embodiments, when it is determined that the measured temperature exceeds the reference temperature but does not reach the second or critical temperature, the device 110 may reduce the amount of charging current and reset the reference temperature in operation 660. In this case, the reference temperature may be set based on the temperature range between the measured temperature, e.g., the current temperature, instead of the temperature at the start of charging of the battery 120, and the second or preset critical temperature.

For example, when the temperature of the battery 120 rises from 35 °C to 41 °C during charging, the device 110 may cause the amount of charging current of the battery 120 to decrease. In some embodiments, the device 110 may control the power conversion device such that the battery 120 is charged with a lower current than before. Accordingly, the device 110 may reduce heat generation during the charging process of the battery 120 and continue charging while providing safety during the charging process of the battery 120. When the charging of the battery 120 is not completed, the device 110 may return to operation 630 and perform temperature monitoring again, thereby repeating the above process.

In an embodiment, when the measured temperature of the battery 120 does not exceed the reference temperature, the device 110 may reset the reference temperature while maintaining the amount of charging current in operation 652. In this case, the reference temperature may be set based on the temperature range between the measured temperature, e.g., the current temperature, instead of the temperature at the start of charging of the battery 120, and the second or preset critical temperature. When the current temperature of the battery 120 is the same as the temperature at the start of charging, the reference temperature may be the same as the reference temperature set in operation 620.

In operation 670, the device 110 may determine whether the battery 120 has reached the end-of-charge voltage. If the end-of-charge voltage is reached, the device 110 may determine that the battery 120 is fully charged and may terminate charging. If the charging of the battery 120 is not yet completed, the device 110 may return to operation S630 and perform temperature monitoring again, thereby repeating the above process.

Through the section-specific temperature monitoring from operation 610 to operation 670 described above, the device 110 may provide safety during the charging process of the battery 120. In particular, the device 110 may perform temperature monitoring (e.g., continuously) during a fast charging process of the battery 120 using high current, such as in an EV, thereby preventing ignition or explosion of the battery 120. The method by which the device 110 sets the monitoring sections is not limited to the above embodiment, and by adjusting the sections, such as by subdividing or simplifying the section width, the device may flexibly respond to environmental changes of the battery 120 during the charging process.

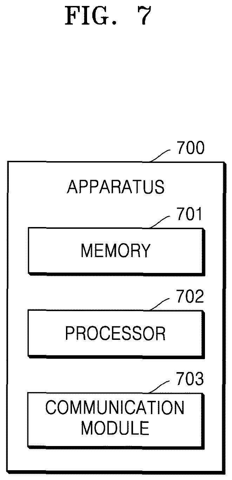

FIG. 7 is a block diagram of a battery management device or apparatus 700 according to one or more embodiments of the present invention.

Referring to FIG. 7, the apparatus 700 may include a processor 702, a memory 701, and a communication module 703. In some embodiments, the apparatus 700 may be the same as the battery management device 110 described above with reference to FIG. 1. Only components related to the embodiment are shown in the apparatus 700 of FIG. 7. Accordingly, it will be understood by those skilled in the art that other general-purpose components may also be included in addition to those illustrated in FIG. 7.

The processor 702 controls the overall operation of the apparatus 700. For example, the processor 702 may control overall operations of the memory 701, the communication module 703, an input unit (not shown), and/or an output unit (not shown) by executing programs stored in the memory 701. The processor 702 may control the operation of the apparatus 700 by executing programs stored in the memory 701.

The processor 702 may control at least some of the operations of the apparatus 700 described above with reference to FIGS. 1 to 6. For example, the processor 702 may control the communication module 703 to obtain base impedance and comparison impedance measurement values for the battery 120 and determine whether to change the end-of-charge voltage based on the obtained measurement values.

A specific example of the operation of the processor 702 is the same as those described above with reference to FIGS. 1 to 6. Therefore, a detailed description of the operation of the processor 702 will be omitted below.

The processor 702 may be realized using at least one of application specific integrated circuits (ASICs), digital signal processors (DSPs), digital signal processing devices (DSPDs), programmable logic devices (PLDs), field programmable gate arrays (FPGAs), controllers, micro-controllers, microprocessors, or electronic units for executing other functions.

The memory 701 is hardware that stores a variety of data processed in the apparatus 700 and may store programs for various operations, processing, and control of the processor 710.

The memory 701 may include random access memory (RAM) such as dynamic random access memory (DRAM) and static random access memory (SRAM), read-only memory (ROM), electrically erasable programmable read-only memory (EEPROM), compact disc read-only memory (CD-ROM), Blu-ray or other optical disk storages, a hard disk drive (HDD), a solid state drive (SSD), or flash memory.

The communication module 703 may include at least one component that enables the apparatus 700 to perform wired/wireless communication with other devices. For example, the communication module 703 may include, but is not limited to, a short-range communication unit and/or a mobile communication unit.

An apparatus for controlling charging of a battery according to an embodiment may include a method having least one program stored therein and a processor 702 configured to operate by executing the program, and the processor 702 may measure a base impedance and a comparison impedance of a battery 120 and calculate an impedance variation based on a difference between them. In some embodiments, the processor 702 may set an end-of-charge voltage based on the calculated impedance variation and charge the battery 120 according to the set end-of-charge voltage.

According to an embodiment, the processor 702 may measure the base impedance at the time of completion of initial charge and measure the comparison impedance at a point in time after the battery 120 is discharged, and the base impedance and the comparison impedance may be measured using EIS.

According to an embodiment, the processor 702 may measure the base impedance at a first discharging time point and measure the comparison impedance at a second discharging time point.

According to an embodiment, the processor 702 may calculate an impedance variation based on a difference between the base impedance and the comparison impedance measured at the same frequency, and the base impedance and the comparison impedance may each include impedance values corresponding to one or more frequency sections.

According to an embodiment, the processor 702 may compare the impedance variation with a reference value, and change the end-of-change voltage when the impedance variation is greater than the reference value.

According to an embodiment, the processor 702 may downwardly adjust or reduce the end-of-charge voltage when the impedance variation is a positive (+) value, and may upwardly adjust or increase the end-of-charge voltage when the impedance variation is a negative (-) value.

According to an embodiment, the processor 702 may divide the voltage between the voltage at the start of charging and the end-of-charge voltage into a plurality of voltage sections, and may generate a plurality of temperature sections corresponding to the respective voltage sections, and the generated temperature sections may be formed by dividing the temperature between the temperature at the start of charging and a critical temperature into multiple sections.

According to an embodiment, the plurality of temperature sections may be divided according to at least one reference temperature and the reference temperature may be a temperature that does not exceed the critical (e.g., a second) temperature.

According to an aspect of the invention described above, the impedance of the battery can be monitored by section using EIS, and by determining timing for terminating charging based thereon, the charging capacity of the battery can be preserved.

In addition, according to an aspect of the invention, the temperature of the battery can be monitored by section, and by adjusting the amount of charging current accordingly, heat generation of the battery can be reduced, to provide safety during charging.

The effects of the embodiments of the invention are not limited to those mentioned above, and other unmentioned effects will be readily understood by those skilled in the art from the description of this specification.

Embodiments according to the invention may be implemented in the form of computer programs that may be executed through various components on a computer, and such computer programs may be recorded in a computer-readable medium. Examples of the medium may include, but are not limited to, magnetic media such as hard disks, floppy disks, and magnetic tapes, optical recording media such as CD-ROM disks and DVD-ROM disks, magneto-optical media such as floptical disks, and hardware devices that are specifically configured to store and execute program instructions, such as ROMs, RAMs, flash memory, and the like.

The computer programs may be those specially designed and constructed for the purposes of the invention or they may be of the kind well known and available to those skilled in the computer software arts. Examples of computer code may include both machine codes, such as produced by a compiler, and higher level code that may be executed by the computer using an interpreter or the like.

According to an embodiment, a method according to various embodiments of the invention may be included and provided in a computer program product. The computer program product may be traded as a product between a seller and a buyer. The computer program product may be distributed in the form of a machine-readable storage medium (e.g., CD-ROM), or be distributed (e.g., downloaded or uploaded) online via an application store (e.g., Play Store^{™}), or between two user devices directly. If distributed online, at least part of the computer program product may be temporarily generated or at least temporarily stored in the machine-readable storage medium, such as memory of the manufacturer's server, a server of the application store, or a relay server.

Operations constituting the method according to the invention may be performed in appropriate order unless explicitly described in terms of order or described to the contrary. The invention is not necessarily limited to the order of operations given in the description. All examples described herein or the terms indicative thereof ("for example," etc.) used herein are merely to describe the invention in greater detail. Therefore, it should be understood that the scope of the invention is not limited to the example embodiments described above or by the use of such terms unless limited by the appended claims. Also, it should be apparent to those skilled in the art that various modifications, combinations, and alternations can be made depending on design conditions and factors within the scope of the appended claims or equivalents thereof.

The invention is thus not limited to the embodiments described above, and rather intended to include the following appended claims, and all modifications, equivalents, and alternatives thereof falling within the spirit and scope of the following claims.

## Claims

1. A method for controlling charging of a battery (120), the method comprising:
measuring (210) a first impedance and a second impedance of the battery (120);
calculating (220, 510) an impedance variation based on a difference between the first impedance and the second impedance;
setting (230) an end-of-charge voltage based on the impedance variation; and
charging (240) the battery based on the end-of-charge voltage;

2. The method of claim 1, wherein the first impedance and the second impedance are measured (210) using electrochemical impedance spectroscopy (EIS).

3. The method according to any one of the preceding claims, wherein the measuring (210) comprises measuring the first impedance at a point in time when initial charging of the battery (120) is completed, and measuring the second impedance at a point in time after the battery (120) is discharged.

4. The method according to any one of the preceding claims, wherein the measuring (210) comprises measuring the first impedance at a first discharging time point of the battery (120) and measuring the second impedance at a second discharging time point of the battery (120).

5. The method according to any one of the preceding claims, wherein
the calculating (220, 510) comprises calculating the impedance variation based on a difference between the first impedance and the second impedance measured at a same frequency, and
the first impedance and the second impedance each include one or more impedance values corresponding to one or more frequency sections.

6. The method according to any one of the preceding claims, wherein the setting (230) comprises:
comparing (520) the impedance variation with a reference value; and
changing (532) the end-of-charge voltage based on the impedance variation being greater than the reference value.

7. The method of claim 6, wherein the changing (532) comprises
Decreasing (551) the end-of-charge voltage based on the impedance variation being a positive (+) value (540), and
increasing (552) the end-of-charge voltage based on the impedance variation being a negative (-) value (540).

8. The method according to any one of the preceding claims, wherein
the charging (240) comprises:
dividing (610) a selected voltage between a first voltage associated with start of charging of the battery (120) and the end-of-charge voltage associated with end of the charging of the battery (120), into a plurality of voltage sections; and
generating (620) a plurality of temperature sections corresponding respectively to the plurality of voltage sections,
wherein the plurality of temperature sections are formed by dividing a selected temperature between a first temperature at a start of charging of the battery and a second temperature of the battery (120), into a plurality of sections.

9. The method of claim 8, wherein
the plurality of temperature sections are divided according to at least one reference temperature, and
the at least one reference temperature does not exceed the second temperature.

10. The method of claim 9, wherein the charging comprises:
Measuring (630) a measured temperature of the battery (120) in a voltage section included in the plurality of voltage sections;
comparing (640) the measured temperature with the at least one reference temperature; and
reducing (660) an amount of charging current based on the measured temperature exceeding the at least one reference temperature.

11. The method of claim 10, wherein the reducing comprises
terminating charging of the battery (120) based on the measured temperature exceeding (651) the second temperature.

12. A battery management apparatus (700), comprising:
a processor (702); and
a memory (701), wherein the memory (701) stores program instructions that, when executed by the processor (702), cause the processor (702) to:
measure (210) a first impedance and a second impedance of a battery (120);
calculate (220, 510) an impedance variation based on a difference between the first impedance and the second impedance;
set (230) an end-of-charge voltage based on the impedance variation; and
charge (240) the battery based on the end-of-charge voltage.

13. The apparatus (700) of claim 12, wherein the program instructions that cause the processor (702) to measure include program instructions that cause the processor (702) to:
Measure (210) the first impedance at a point in time when initial charging of the battery is completed (120) and the second impedance at a point in time when the battery (120) is discharged, wherein the first impedance and the second impedance are measured using electrochemical impedance spectroscopy (EIS).

14. The apparatus (700) according to any one of claims 12-13, wherein the program instructions that cause the processor (702) to measure include instructions that cause the processor (702) to:
Measure (210) the first impedance at a first discharging time point of the battery (120) and measure the second impedance at a second discharging time point of the battery (120).

15. A computer-readable, non-transitory storage medium having recorded thereon a program for causing a computer to execute the method according any one of claims 1-11.
